(19) Europäisches Patentamt
European Patent Office
Office européen des brevets

(11) **EP 4 322 200 A1**

(12) **EUROPEAN PATENT APPLICATION**

(43) Date of publication:
**14.02.2024 Bulletin 2024/07**

(21) Application number: **23186677.3**

(22) Date of filing: **20.07.2023**

(51) International Patent Classification (IPC):
**H01J 37/32** (2006.01)     **H01L 21/683** (2006.01)
**H01L 21/687** (2006.01)

(52) Cooperative Patent Classification (CPC):
**H01J 37/32642; H01J 37/32697; H01L 21/6833;
H01L 21/68735**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.08.2022   KR 20220099835**

(71) Applicant: **SK enpulse Co., Ltd.
Pyeongtaek-si, Gyeonggi-do 17784 (KR)**

(72) Inventors:
• **MIN, Kyungyeol
03142 Seoul (KR)**

• **CHOI, Yongsoo
03142 Seoul (KR)**
• **Hwang, SungSic
03142 Seoul (KR)**
• **KIM, Kyungin
03142 Seoul (KR)**
• **KANG, Jungkun
03142 Seoul (KR)**
• **CHAE, Su Man
03142 Seoul (KR)**

(74) Representative: **BCKIP Part mbB
Siegfriedstraße 8
80803 München (DE)**

(54) **FOCUS RING AND PLASMA ETCHING APPARATUS COMPRISING THE SAME**

(57)     A plasma etching apparatus includes a chamber configured to generate plasma, an electrostatic chuck disposed in the chamber, and a focus ring placed on the electrostatic chuck and configured to support an object to be etched. The focus ring includes a seating part and a body part. A seating surface is provided on at least a portion of the seating part configured to seat the object to be etched thereon. The focus ring further includes a step provided between the seating part and the body part. The body part includes a body area and a chucking reinforcement area. The body area includes a first corrosion resistant layer, and the chucking reinforcement area includes a second corrosion resistant layer. The second corrosion resistant layer is thinner than the first corrosion resistant layer, and has a minimum thickness of 1 mm or more.

Fig. 2

**(Cont. next page)**

Fig. 3

## Description

BACKGROUND

1. Field

The following description relates to a focus ring and a plasma etching apparatus including the same.

2. Discussion of Related Art

Plasma etching, typically a dry etching, is performed on a substrate to form fine patterns of highly integrated semiconductor devices. A plasma etching apparatus includes a chamber, an electrostatic chuck disposed within the chamber, and devices such as electrodes installed above and below the electrostatic chuck to supply high-frequency power. The plasma etching process may be performed by converting gas introduced into the chamber into a plasma using a high-frequency power source supplied between the electrodes, and using the plasma to etch a substrate mounted on the electrostatic chuck. The radicals or ions that make up the plasma react physically and chemically with the substrate surface to etch the substrate.

Plasma is generated by the plasma etching apparatus using high-frequency power supplied from above and below the electrostatic chuck on which an object to be etched is placed and thus is easy to control in the area where the high-frequency power is supplied, but is relatively difficult to control directly on the outer side of the electrostatic chuck. Because the amount of plasma generated on the outer side of the electrostatic chuck is relatively small, the etch rate at the edge of the substrate may be slightly lower than the etch rate in the central area of the substrate. Accordingly, it may be difficult to uniformly etch the entire surface of the substrate.

In order to improve the etching uniformity of the substrate, a focus ring is provided on the outer circumference of the object to be etched, and is arranged in an electrostatic chuck to surround the object. When performing plasma etching in the etching apparatus, the focus ring guides the plasma to flow toward the surface of the object to be etched, thereby improving the processing efficiency.

In order to improve the processing efficiency of an object using a focus ring, many attempts have been made to manufacture the focus ring in various shapes, for example, in an inclined shape. However, it has been reported that etching is not performed stably due to shaking of the focus ring, etc. during the etching process.

Accordingly, there is a need for a method in which the focus ring can be fixed more stably to satisfy uniform etching of the etched object.

The foregoing background technology is technical information processed by the inventor to derive embodiments or acquired in the process of deriving embodiment, and thus may not necessarily have been known to the public prior to the filing of the present disclosure.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a plasma etching apparatus includes a chamber configured to generate plasma, an electrostatic chuck disposed in the chamber; and a focus ring placed on the electrostatic chuck and configured to support an object to be etched. The focus ring includes a seating part and a body part, and a seating surface is provided on at least a portion of the seating part configured to seat the object to be etched thereon. A step is provided between the seating part and the body part, and the body part comprises a body area and a chucking reinforcement area. The body area includes a first corrosion resistant layer and the chucking reinforcement area includes a second corrosion resistant layer. The second corrosion resistant layer is thinner than the first corrosion resistant layer, and the second corrosion resistant layer has a minimum thickness of 1 mm or more.

The focus ring may be configured to increase a chucking force by 30% or more compared to a focus ring not using the chucking reinforcement area.

The plasma etching apparatus may further include a gas layer positioned between the focus ring and the electrostatic chuck, and the gas layer is configured to flow an inert gas at a flow rate of 3 sccm to 20 sccm.

In another general aspect, a focus ring includes a seating part and a body part. A seating surface is provided on at least a portion of the seating part configured to seat an object to be etched. A step is provided between the seating part and the body part, and the body part includes a body area and a chucking reinforcement area. The body area further includes a first corrosion resistant layer, and the chucking reinforcement area includes a second corrosion resistant layer. The second corrosion resistant layer is thinner than the first corrosion resistant layer, and the second corrosion resistant layer has a minimum thickness of 1 mm or more.

The chucking reinforcement area may further include a chucking enhancement layer on the second corrosion resistant layer, and the chucking enhancement layer may include a material having a dielectric constant lower than that of the second corrosion resistant layer.

The chucking enhancement layer may include an air layer or a vacuum layer.

The second corrosion resistant layer may have a flexural strength of 300 MPa or greater.

The first corrosion resistant layer and the second corrosion resistant layer each may independently include one selected from the group consisting of silicon, silicon carbide, boron carbide, and a combination thereof.

The first corrosion resistant layer may have an average thickness of 3.6 mm or less.

When V1 represents a volume of the focus ring including the chucking enhancement layer and V2 represents a volume of the chucking enhancement layer, a ratio of V2 to V1 may be at least 15% when V1 is 100%.

The focus ring and the chucking reinforcement area each may be in a form of a ring, and when W represents a length from an inner diameter of the seating part to an outer diameter of the body part, D represents a distance from an upper surface of the body part to a bottom surface of the body part opposite to the upper surface of the body part, and A represents a cross-sectional area of the chucking enhancement layer when viewed from a cross section of the focus ring in a thickness direction, a ratio of A may be 20% or greater when the product of W and D is 100%.

In another general aspect, a manufacturing method of a substrate includes etching a substrate by applying a plasma etching apparatus. The plasma etching apparatus includes a chamber configured to generate plasma; an electrostatic chuck disposed in the chamber; and a focus ring placed on the electrostatic chuck and configured to support an object to be etched. The focus ring includes a seating part and a body part. A seating surface is provided on at least a portion of the seating part configured to seat the object to be etched thereon. A step is provided between the seating part and the body part. The body part includes a body area and a chucking reinforcement area. The body area includes a first corrosion resistant layer, and the chucking reinforcement area includes a second corrosion resistant layer. The second corrosion resistant layer is thinner than the first corrosion resistant layer, and the second corrosion resistant layer has a minimum thickness of 1 mm or more.

Other features and aspects will be apparent from the following detailed description, the drawings, and the claims.

BRIEF DESCRIPTION OF THE DRAWINGS

FIG. 1 illustrates a schematic cross-sectional view of an example of a plasma etching apparatus according to an embodiment;
FIG. 2 illustrates a schematic cross-sectional view of a part of a focus ring used in a plasma etching apparatus according to an embodiment;
FIG. 3 illustrates a conceptual view illustrating a cross section of a part of a right side of a focus ring according to an embodiment;
FIG. 4 illustrates a top plan view of a focus ring according to an embodiment; and
FIG. 5 illustrates a conceptual view of an example of a region related to a right part of a cross section of a focus ring according to an embodiment.

Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

Due to manufacturing techniques and/or tolerances, variations of the shapes shown in the drawings may occur. Thus, the examples described herein are not limited to the specific shapes shown in the drawings, but include changes in shape that occur during manufacturing.

Unless otherwise defined, all terms, including technical and scientific terms, used herein have the same meaning as commonly understood by one of ordinary skill in the art to which this disclosure pertains specifically in the context on an understanding of the disclosure of the present application. Terms, such as those defined in commonly used dictionaries, are to be interpreted as having a meaning that is consistent with their meaning in the context of the relevant art and specifically in the context of the disclosure of the present application, and are not to be interpreted in an idealized or overly formal sense unless expressly so defined herein.

## PLASMA ETCHING APPARATUS

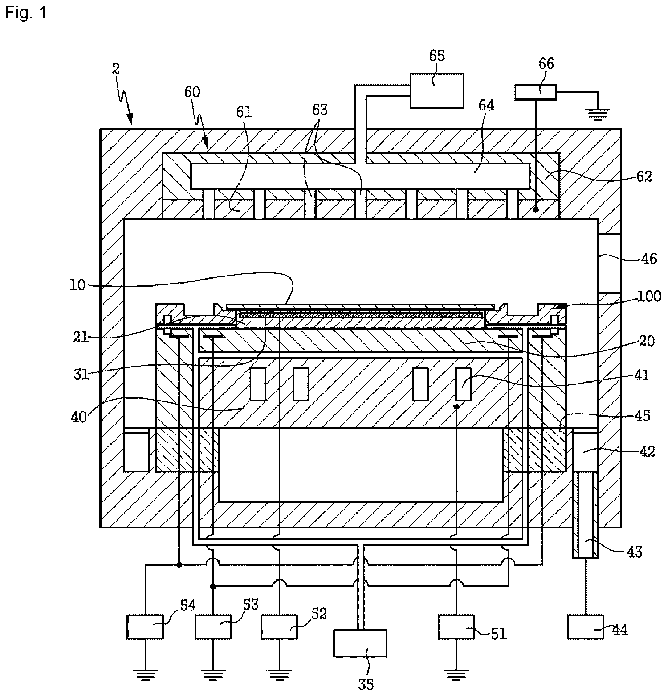

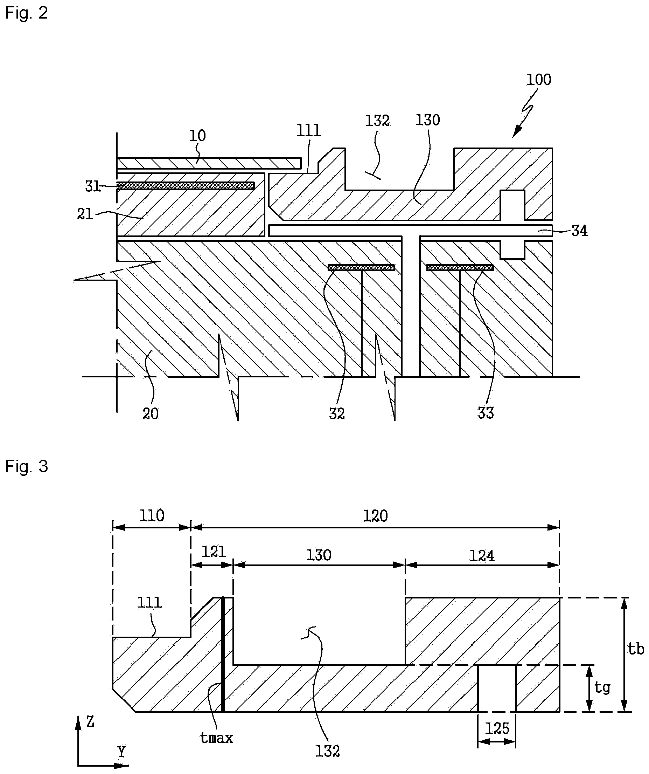

FIGS. 1 and 2 illustrate schematic views of a plasma etching apparatus according to an embodiment. Hereinafter, the plasma etching apparatus according to the embodiment will be described with reference to FIGS. 1 and 2.

The plasma etching apparatus according to the embodiment may include a chamber 2 in which plasma is formed, an electrostatic chuck 20 disposed inside the chamber 2, and a focus ring 100 mounted on the electrostatic chuck 20 to support an object 10 to be etched.

The focus ring 100 may include a seating part 110 and a body part 120.

A seating surface 111 is provided on at least a portion of the seating part 110 configured to seat the object 10 to be etched thereon.

There may be a step between the seating part 110 and the body part 120.

The body part 120 may include a body area 121 and a chucking reinforcement area 130.

The body area 121 may include a first corrosion resistant layer.

The chucking reinforcement area 130 may include a second corrosion resistant layer.

The second corrosion resistant layer may be thinner than the first corrosion resistant layer.

The second corrosion resistant layer may have a minimum thickness of 1 mm or more.

An upper electrostatic chuck 21 configured to hold a substrate to be etched, such as a wafer, may be disposed inside the chamber 2.

The upper electrostatic chuck 21 and the electrostatic chuck 20 may have a volume resistance sufficient to apply a Coulomb force, and may include ceramic materials such as aluminum nitride, silicon nitride, or aluminum oxide.

In the upper electrostatic chuck 21, a first electrode 31 may be disposed to generate an electrostatic force to induce electrostatic adsorption when the object 10 to be etched is placed on the upper surface of the electrostatic chuck 20. The first electrode 31 may be electrically connected to a first power source 52, which is a direct-current (DC) power source, to receive a DC power supply, and may maintain electrostatic adsorption between the electrostatic chuck 20 and the object 10 to be seated on the electrostatic chuck 20.

A shower head 60 may be provided above the upper electrostatic chuck 21 to face the upper electrostatic chuck 21.

The shower head 60 may include an upper electrode 61 and an electrode support 62 supporting the upper electrode 61. A plurality of through-holes 63 may be formed in the upper electrode 61 and the electrode support 62. A diffusion part 64 may be provided in the shower head 60 to communicate with the through-holes 63.

The upper electrode 61 of the shower head 60 may be electrically connected to an upper power supply 66 and supplied with high-frequency power.

The diffusion part 64 in the shower head 60 may communicate with a processing gas supply part 65, and a processing gas from the processing gas supply part 65 may be discharged to the outside through the diffusion part 64 and the through-holes 63.

The electrostatic chuck 20 may be disposed below the focus ring 100.

A base 40 may be disposed below the electrostatic chuck 20 and include a conductive material.

The base 40 may be electrically connected to a high-frequency power source 51 to provide high-frequency power for plasma generation. Thus, a high-frequency power source may be supplied to the base 40.

A base cooling part 41 may be included in the base 40, and may communicate with the cooling gas supply part 35 to form a flow of a cooling gas.

An exhaust passage 42 may be formed between a side wall of the chamber 2 and the base 40 or a support 45 supporting the base 40. An exhaust port 43 may be provided below the exhaust passage 42, and communicate with an exhaust device 44. The exhaust device 44 may include exhaust means, such as a vacuum pump, and may depressurize the pressure of the space within the chamber 2 to a certain degree of vacuum.

The side walls of the chamber 2 may be provided with an entrance 46 through which the object 10 to be etched may be loaded or unloaded.

The focus ring 100 may be disposed around the outer periphery of the object 10 disposed on the upper electrostatic chuck 21. The focus ring 100 will be described in more detail below.

A gas layer 34 may be provided on the electrostatic chuck 20 in the lower region of the focus ring 100 to provide cooling gas, or may be provided between the focus ring 100 and the electrostatic chuck 20.

The gas layer 34 may include an inert gas flowing at a flow rate of 3 sccm to 20 sccm.

The focus ring 100 may include a chucking reinforcement area 130, which is a unique region for reliably chucking with the electrostatic chuck 20 across the gas layer 34 during plasma etching, and for maintaining an overall balance.

The chucking force may be enhanced by the focus ring 100 by more than 30%, more than 200%, or more than 450% compared to a focus ring that does not utilize the chucking reinforcement area 130. The chucking force may be improved by 500% or less compared to a focus ring that does not utilize the chucking reinforcement area 130. When the chucking force is improved within the range of the rates described above, it is possible to stably chuck with the electrostatic chuck 20 and maintain the overall balance, thus contributing to effective plasma etching. The chucking force may be roughly calculated according to Equation 1 below, and can be understood as the electrostatic attraction between the electrostatic chuck 20 and the focus ring 100 when power is supplied to the electrodes in the plasma etching apparatus.

The cooling gas supply part 35 may supply a cooling gas not only to the gas layer 34 facing the focus ring 100 but also a space between the upper electrostatic chuck 21 and the object 10 to be etched through a separate flow path.

In an example, helium gas may be used as the cooling gas.

In the electrostatic chuck 20, a second electrode 32 and a third electrode 33 may be provided in a region below the focus ring 100, and may be respectively electrically connected to a second power source 53 and a third power source 54 to supply DC power to the second and third electrodes 32 and 33. Thus, electrostatic adsorption may occur between the focus ring 100 and the electrostatic chuck 20 under the focus ring 100.

The components of the plasma etching apparatus may be connected to a controller.

The controller may include a central processing unit (CPU) and a memory device, and may read and execute a program and a processing process stored in the memory device to control processing for electrostatic adsorption of the focus ring 100 or the supply of a cooling gas according to processing performed by the plasma etching apparatus.

A horizontal magnetic field may be formed in one direction inside the chamber 2 through a separate magnet.

A high-frequency electric field may be formed in one direction inside the chamber 2 by high-frequency power supplied between the base 40 and the shower head 60. Accordingly, magnetron discharge may be performed by a process gas in the chamber 2, high-density plasma may be generated from the process gas on the object 10 to be etched, which is placed on the upper electrostatic chuck 21 above the base 40, and a surface of the object 10 may be etched by radicals or ions in the plasma.

The etching may be performed by the plasma etching apparatus for about 100 hours or more under a chamber pressure of about 500 mTorr or less using a process gas including a fluorine-containing compound or a chlorine-containing compound and power of about 500 W to 15,000 W.

FOCUS RING (100)

FIGS. 2 to 5 illustrate schematic views of the focus ring 100 according to the embodiment. The focus ring 100 according to the embodiment will be described with reference to FIGS. 2 to 5 below.

In an example, the focus ring 100 may include a seating part 110 and a body part 120.

A seating surface 111 is provided on at least a portion of the seating part configured to seat the object to be etched thereon.

There may be a step between the seating part 110 and the body part 120.

The body part 120 may include a body area 121 and a chucking reinforcement area 130.

The body area 121 may include a first corrosion resistant layer.

The chucking reinforcement area 130 may include a second corrosion resistant layer.

The second corrosion resistant layer may be thinner than the first corrosion resistant layer.

The second corrosion resistant layer may have a minimum thickness of 1 mm or more.

An average thickness of the second corrosion resistant layer may be in a range of about 0.5 mm to 2.3 mm or a range of about 1 mm to 2 mm.

The seating part 110 may include a seating surface 111 configured to seat the object 10 to be etched thereon. The seating surface 111 may have a certain width in a radial direction of the focus ring 100 and be a flat surface on which the object 10 to be etched may be seated.

The average thickness of the seating part 110 may be in the range of about 1 mm to 2 mm or in the range of about 1.2 mm to 1.8 mm.

The average height of the seating part 110 in a direction perpendicular to the radial direction of the focus ring 100 may be in the range of about 1 mm to 2 mm, or in the range of about 1.2 mm to 1.8 mm.

The width of the seating part 110 in the radial direction of the focus ring 100 may be in the range of about 2 mm to 8 mm, or in the range of about 3 mm to 7 mm.

The object 10 to be etched may be seated on the seating part 110 with sufficient spacing, and safety may be ensured due to the thickness, height, and width of the seating part 110 described above.

The body part 120 may have a thickness equal to or greater than the thickness of the seating part 110 and extend to the outer circumference of the focus ring 100.

The body part 120 may include a body area 121 around a periphery of the seating part 110. The body area 121 may include a first corrosion resistant layer, and an upper surface of the first corrosion resistant layer may be substantially parallel to the seating surface 111 or located at an average height above the seating surface 111. The upper surface of the first corrosion resistant layer may be completely sloped, or a portion of the upper surface of the first corrosion resistant layer may be sloped, and another portion of the upper surface of the first corrosion resistant layer may be substantially parallel to the upper surface of the seating part 110. The inclination angle of the inclined portion of the first corrosion resistant layer may be greater than 0° or less than 70° with respect to the upper surface of the seating part 110. By the inclination angle of the first corrosion resistant layer, the flow of plasma ions in the plasma etching apparatus may be more reliably controlled. The width of the body area 121 in the radial direction of the focus ring 100 may be in the range of about 1 mm to 3 mm, or in the range of about 1.5 mm to 2.5 mm.

The average thickness of the first corrosion resistant layer of the body area 121 may be 3.6 mm or less, 3.3 mm or less, or 2.7 mm or less. The average thickness of the first corrosion resistant layer may be greater than or equal to 1 mm, or greater than or equal to 1.5 mm. The maximum thickness tmax of the first corrosion resistant layer may be 3.7 mm or less, or 3.3 mm or less. The maximum thickness tmax may be greater than or equal to 1.7 mm or greater than or equal to 2 mm. Due to the width and thickness of the first corrosion resistant layer, the flow of plasma ions in the plasma etching apparatus may be more reliably controlled.

The ratio Ws/Wg between the width Ws of the body area 121 and the width Wg of the chucking reinforcement area 130 in the radial direction of the focus ring 100 may be in the range of about 0.04 to 0.2, or in the range of about 0.05 to 0.16. The focus ring 100 having such a ratio Ws/Wg may prevent a decrease in etch uniformity due to groove geometry during plasma etching.

The luminance level Ra of the upper surface of the body part 120 may be in a range of about 0.05 $\mu$m to 0.5 $\mu$m, or in a range of about 0.08 $\mu$m to 0.3 $\mu$m. By such a luminance level Ra, a high etch rate of the object to be etched may be achieved during the etching process performed by the plasma etching apparatus.

The chucking reinforcement area 130 may include a second corrosion resistant layer connected to the first corrosion resistant layer.

The average height of the second corrosion resistant layer in a direction perpendicular to the radial direction of the focus ring 100, may be in a range of about 0.5 mm to 2.3 mm, or in a range of about 1 mm to 2 mm.

The maximum width of the second corrosion resistant layer in the radial direction of the focus ring 100 may be in the range of about 15 mm to 25 mm, or in the range of about 17 mm to 22 mm.

The ratio Tg/Tb between an average thickness Tg of the second corrosion resistant layer and an average thickness Tb of the body part 120 excluding the second corrosion resistant layer may be in a range of about 0.16 to 0.72, or in a range of about 0.19 to 0.58.

The average thickness Tg of the second corrosion resistant layer and the average thickness Tb of the body part 120 excluding the second corrosion resistant layer may be calculated by dividing each of the second corrosion resistant layer and the body part 120 each into n equal parts in the radial direction of the focus ring 100 and calculating the average of thicknesses of the n equal parts, where n may be an integer from 3 to 10. Additionally, means for calculating the average thickness through modeling (e.g., CATIA, SolidWorks, AutoCAD or the like) may be used.

By the thickness, height, width, and ratio Tg/Tb of the second corrosion resistant layer, damage or cracking may be prevented, and the focus ring 100 may reliably induce adsorption of the electrostatic chuck 20 of the plasma etching apparatus.

The thickness of the second corrosion resistant layer in a longitudinal direction may be uniform or non-uniform.

The upper surface of the second corrosion resistant layer may be substantially parallel to the seating surface 111, a portion of the upper surface may be curved, and a remaining portion may be angled.

The second corrosion resistant layer may have flexural strength of greater than 300 MPa and less than or equal to 450 MPa. In this case, a focus ring having a high strength may be provided even when the chucking enhancement layer 132 to be described below is applied.

The first corrosion resistant layer and the second corrosion resistant layer may each independently include a material selected from the group consisting of silicon, silicon carbide, boron carbide, and a combination thereof.

The chucking reinforcement area 130 may further include a chucking enhancement layer 132 on the second corrosion resistant layer, and the chucking enhancement layer 132 may include a material having a dielectric constant lower than that of the second corrosion resistant layer.

The chucking enhancement layer 132 may be formed such that a side wall of the second corrosion resistant layer is perpendicular to an upper surface thereof and thus may have a substantially quadrangular shape.

The chucking enhancement layer 132 may have a substantially quadrant or triangular cross-section with one side formed by a virtual line substantially parallel to the seating surface 111 and the sidewalls of the second corrosion resistant layer intersecting each other at right angles, and another side that slopes as it extends from the side.

The chucking enhancement layer 132 may have a concave surface, a convex surface, or a combination thereof, since the upper surface of the second corrosion resistant layer is curved.

The chucking enhancement layer 132 may be an air layer or a vacuum layer. The chucking enhancement layer 132 may be formed by processing, e.g., grinding or etching, the second corrosion resistant layer, or by processing and sealing the second corrosion resistant layer.

The volume of the chucking enhancement layer 132 may be in the range of, for example, about 8,268 $mm^3$ to 41,342 $mm^3$ or about 15,720 $mm^3$ to 29,501 $mm^3$, but may depend on the size of the focus ring 100, which varies with the diameter and size of the object 10 to be etched.

The chucking force Fc between the focus ring 100 including the chucking enhancement layer 132 and the electrostatic chuck 20 of the plasma etching apparatus may be approximately calculated according to Equation 1 below.

[Equation 1]

$$Fc = (\varepsilon_0 \times \varepsilon_r \times A \times V)/(2 \times D^2)$$

In Equation 1 above, $\varepsilon_0$ represents the space permittivity, $\varepsilon_r$ represents the permittivity of the focus ring, A represents the cross-sectional area of the focus ring in contact with an electrostatic chuck, V represents the voltage applied to the electrodes under the electrostatic chuck in contact with the focus ring, and D represents the average thickness of the focus ring.

The chucking force Fc is not an absolute value, but should be understood as a relative value, and is inversely proportional to the square of the average thickness of the focus ring when other conditions are equal.

The average thickness or height of the focus ring 100 may be about 3.2 mm or less, about 3.0 mm or less, or about 2.7 mm or less. The average thickness or height of the focus ring 100 may be greater than or equal to about 1.7 mm, or greater than or equal to about 2 mm. A focus ring satisfying the above thickness or height ranges may have suitable chucking reinforcement area, as described above, to reliably hold onto the electrostatic chuck of the plasma etching apparatus and exhibit high durability.

When V1 represents the volume of the focus ring 100 including the chucking enhancement layer 132, and V2 represents the volume of the chucking enhancement layer 132, the ratio of V2 to V1 may be 15% or more or 50% or less than 50% when V1 is 100%. The ratio of V2 may be 20% or more or 35% or less than 35% when V1 is 100%. A focus ring with the ratio of V2 to V1 may induce more stable electrostatic adsorption with the electrostatic chuck of the plasma etching apparatus under the focus ring and improve the chucking force between the electrostatic chuck and the focus ring. When the ratio is lower than or exceeds the above range, stable fixation may not be achieved, wear resistance may decrease, and cracking may occur.

V1, V2, and the like may be calculated and measured by any means for calculating a modeling volume (CATIA, SolidWorks, AutoCAD or the like).

V2 may also be calculated according to Equation 2 below.

[Equation 2]

$$V2 = (Hb-Hg) \times Wavg \times Lsum$$

In Equation 2 above, Hb represents a maximum height of the upper surface of the body part 120, Hg represents an average height of the second corrosion resistant layer, Wavg represents an average width of the second corrosion resistant layer in a radial direction (a y-axis direction of FIG. 3) of the focus ring 100, and Lsum represents a sum of lengths of the second corrosion resistant layer in a circumferential direction of the focus ring 100.

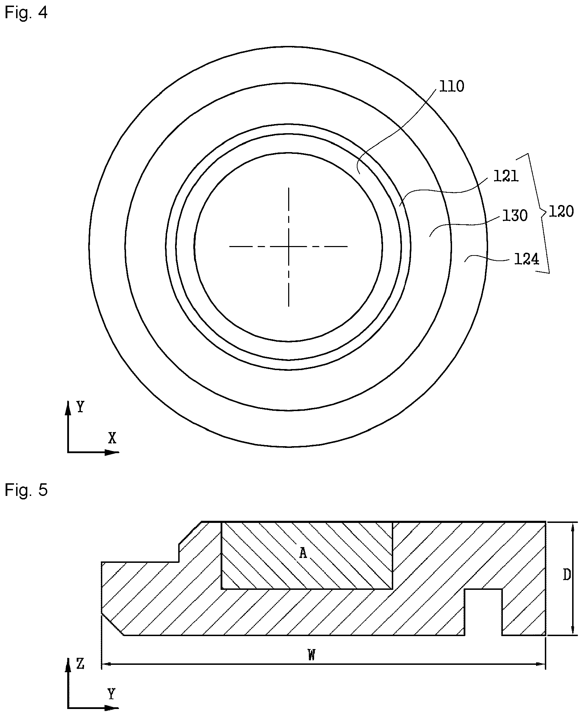

The focus ring 100 may be in the form of a ring, and the chucking reinforcement area 130 may also be in the form of a ring. Referring to FIG. 5, W represents a length from an inner diameter of the seating part 110 to an outer diameter of the body part 120, D represents a distance from an upper surface of the body part 120 to a bottom surface of the body part 120 opposite to the upper surface thereof, A represents a cross-sectional area of the chucking enhancement layer 132 when viewed from a cross section of the focus ring 100 in a thickness direction, and a ratio of A may be 20% or more when the product of W and D is 100%. The ratio of A may be 30% or more or 55% or less. The focus ring 100 with the ratio of A that is within the above range includes a chucking enhancement layer having appropriate volume and thus may be stably fixed with an electrostatic chuck of a plasma etching apparatus, have high abrasion resistance, and prevent cracks from occurring.

The body part 120 of the focus ring 100 may include an edge area 124 on an outer circumference of the chucking reinforcement area 130.

The edge area 124 may include a third corrosion resistant layer which may be connected to the second corrosion resistant layer, and an average thickness of the third corrosion resistant layer may be greater than that of the second corrosion resistant layer.

The average thickness of the third corrosion resistant layer may be in the range of about 1.7 mm to 3.7 mm, or in the range of about 1.9 mm to 3.5 mm. The third corrosion resistant layer having said average thickness may allow the focus ring 100 to maintain an overall balance when placed on the electrostatic chuck of a plasma etching apparatus.

The edge area 124 may further include a bottom surface groove portion 125, which is a groove formed in a portion of the bottom surface of the third corrosion resistant layer.

A minimum width from the bottom surface of the second corrosion resistant layer to the bottom surface groove portion 125 in a radial direction of the focus ring 100 may be in a range of about 0.5 mm to 5 mm, or in a range of about 1 mm to 3 mm. By satisfying the above minimum width range, an appropriate cooling efficiency may be achieved during plasma etching.

The inner diameter may vary according to the length or diameter of the object 10 to be etched, and may be in the range of about 100 mm to 400 mm, for example, with respect to the inner side of the focus ring 100.

Similar to the inner diameter, the outer diameter may vary according to the length or diameter of the object 10 to be etched, and may be in the range of about 150 mm to 500 mm, for example, with respect to the outer side of the focus ring 100.

The bottom surface of the focus ring 100 may be inclined such that the step difference between the inner side and the outer side is in the range of about 0.1 $\mu$m to 12 $\mu$m, or in the range of about 1 $\mu$m to 7 $\mu$m. The inclined focus ring as described above enables cooling gas to be effectively circulated on its bottom surface, and enables the object to be etched to be uniformly etched during plasma etching.

The focus ring 100 may include silicon carbide (SiC) or boron carbide ($B_4C$). The silicon carbide or boron carbide is a material having very high strength and excellent chemical and corrosion resistance.

In an example, silicon carbide includes all silicon-and-carbon-based compounds, and boron carbide includes all boron-and-carbon-based compounds. The silicon carbide or boron carbide may have a single phase or a complex phase. Here, the single phase includes both stoichiometric phases and non-stoichiometric phases that deviate from the stoichiometric composition. In an example, the silicon carbide or boron carbide may include a solid solution formed when impurities are added to the single phase or complex phase, or a mixture of impurities inevitably added during the manufacturing process.

The boron carbide used in the focus ring 100 may have a thermal conductivity of about 5 W/mK to 60 W/mK when measured at temperature from 25 °C to 800 °C. The boron carbide having the thermal conductivity described above may have good etch resistance.

The boron carbide applied to the focus ring 100 may have a relative density of about 97% to 99.999%.

The boron carbide applied to the focus ring 100 may have a porosity of about 0.01% to 3%.

The focus ring 100 having the relative density and porosity described above may have good etch resistance.

The upper surface of the body part 120 of the focus ring 100 may have an etch rate of about 0.5% to 1.2% when etched with a plasma power of about 800 W under a chamber pressure of about 100 mTorr for an exposure time of about 300 minutes. By using a focus ring having the above etch rate in the plasma etching apparatus, the durability of the focus ring may be increased and the replacement frequency may be reduced. The etch rate is evaluated according to an average etch rate of the upper surface of the body part 120. The average etch rate of the upper surface is evaluated by measuring the average of etch rates measured at at least three points on the upper surface at a certain distance from each other.

MANUFACTURING METHOD OF SUBSTRATE

A manufacturing method of a substrate according to an embodiment may include a process of etching a substrate by applying the plasma etching apparatus described above.

The process of etching the substrate may include reading and executing the program and the processing process stored in the memory device of the controller of the plasma etching apparatus to control electrostatic adsorption of the focus ring 100 or the supply of cooling gas by the plasma etching apparatus.

In the process of etching the substrate, a horizontal magnetic field may be formed in one direction inside the chamber 2 of the plasma etching device via separate magnets.

In the process of etching the substrate, a high-frequency electric field may be formed inside the chamber 2 of the plasma etching apparatus in one direction by using a high-frequency power supplied between the base 40 and the shower head 60. Accordingly, a magnetron discharge may be made by the process gas in the chamber 2, a high-density plasma may be generated from the process gas on the object 10 to be etched, which is placed on the upper electrostatic chuck 21 above the base 40, and the surface of the object 10 may be etched by radicals or ions in the plasma.

The process of etching the substrate may be performed for about 100 hours or more under a chamber pressure of about 500 mTorr or less, using a process gas including a fluorine-containing compound or a chlorine-containing compound and a power of about 500 W to 15,000 W.

The focus ring according to embodiments may exhibit high durability and corrosion resistance while satisfying improved electrostatic attraction with an electrostatic chuck of the plasma etching apparatus.

Using a plasma etching apparatus with a focus ring according to one or more embodiments, a uniform etch rate can be achieved during plasma etching of an object to be etched.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is also inclusive of the claims and their equivalents, i.e., all variations within the scope of the claims and their equivalents are to be construed as being included in the disclosure.

**Claims**

1. Plasma etching apparatus, comprising:

   a chamber configured to generate plasma;
   an electrostatic chuck disposed in the chamber; and
   a focus ring placed on the electrostatic chuck and configured to support an object to be etched,
   wherein the focus ring comprises a seating part and a body part,
   wherein a seating surface is provided on at least a portion of the seating part configured to seat the object to be etched thereon,
   wherein a step is provided between the seating part and the body part,
   wherein the body part comprises a body area and a chucking reinforcement area,
   wherein the body area comprises a first corrosion resistant layer, and the chucking reinforcement area comprises a second corrosion resistant layer,
   wherein the second corrosion resistant layer is thinner than the first corrosion resistant layer, and
   wherein the second corrosion resistant layer has a minimum thickness of 1 mm or more.

2. Plasma etching apparatus of claim 1, further comprises a gas layer positioned between the focus ring and the electrostatic chuck,
   wherein the gas layer is configured to flow an inert gas at a flow rate of 3 sccm to 20 sccm.

3. Focus ring comprising:

   a seating part and a body part,
   wherein a seating surface is provided on at least a portion of the seating part configured to seat an object to be etched,
   wherein a step is provided between the seating part and the body part,
   wherein the body part comprises a body area and a chucking reinforcement area,
   wherein the body area comprises a first corrosion resistant layer, and the chucking reinforcement area comprises a second corrosion resistant layer,
   wherein the second corrosion resistant layer is thinner than the first corrosion resistant layer, and
   wherein the second corrosion resistant layer has a minimum thickness of 1 mm or more.

4. Focus ring of claim 3, wherein the chucking reinforcement area further comprises a chucking enhancement layer on the second corrosion resistant layer, and
   wherein the chucking enhancement layer comprises a material having a dielectric constant lower than that of the second corrosion resistant layer.

5. Focus ring of claim 4, wherein the chucking enhancement layer comprises an air layer or a vacuum layer.

**6.** Focus ring of claim 3, wherein the first corrosion resistant layer and the second corrosion resistant layer each independently comprise one selected from the group consisting of silicon, silicon carbide, boron carbide, and a combination thereof.

**7.** Focus ring of claim 3, wherein the first corrosion resistant layer has an average thickness of 3.6 mm or less.

**8.** Focus ring of claim 4, wherein when V1 represents a volume of the focus ring including the chucking enhancement layer and V2 represents a volume of the chucking enhancement layer, a ratio of V2 to V1 is at least 15% when V1 is 100%.

**9.** Focus ring of claim 4, wherein the focus ring and the chucking reinforcement area each are in a form of a ring, and
wherein when W represents a length from an inner diameter of the seating part to an outer diameter of the body part, D represents a distance from an upper surface of the body part to a bottom surface of the body part opposite to the upper surface of the body part, and A represents a cross-sectional area of the chucking enhancement layer when viewed from a cross section of the focus ring in a thickness direction, a ratio of A is 20% or greater when the product of W and D is 100%.

**10.** Manufacturing method of a substrate, the method comprising:

etching a substrate by applying a plasma etching apparatus,
wherein the plasma etching apparatus comprises:

a chamber configured to generate plasma;
an electrostatic chuck disposed in the chamber; and
a focus ring placed on the electrostatic chuck and configured to support an object to be etched,
wherein the focus ring comprises a seating part and a body part,
wherein a seating surface is provided on at least a portion of the seating part configured to seat the object to be etched thereon,
wherein a step is provided between the seating part and the body part,
wherein the body part comprises a body area and a chucking reinforcement area,
wherein the body area comprises a first corrosion resistant layer, and the chucking reinforcement area comprises a second corrosion resistant layer,
wherein the second corrosion resistant layer is thinner than the first corrosion resistant layer, and
wherein the second corrosion resistant layer has a minimum thickness of 1 mm or more.

Fig. 1

Fig. 2

Fig. 3

Fig. 4

110
121
130 } 120
124

Y
X

Fig. 5

A

D

W

Z
Y

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2018 107433 A (TOKYO ELECTRON LTD) 5 July 2018 (2018-07-05) | 1-5,7-10 | INV. H01J37/32 H01L21/683 H01L21/687 |
| Y | * abstract; figures 1,12,13 * * paragraphs [0001], [0018] – [0034], [0050] – [0053], [0070] – [0087] * | 6 | |
| Y | US 2020/185256 A1 (NGUYEN ANDREW [US] ET AL) 11 June 2020 (2020-06-11) | 6 | |
| A | * abstract; figures 1,2 * * paragraphs [0002], [0021] – [0031] * | 1-5,7-10 | |
| A | CN 107 644 802 B (ADVANCED MICRO FAB EQUIP INC) 6 September 2019 (2019-09-06) * abstract; figures 1,2 * * paragraphs [0001], [0052] – [0055] * | 1-10 | |

TECHNICAL FIELDS SEARCHED (IPC)

H01J
H01L

The present search report has been drawn up for all claims

| Place of search | Date of completion of the search | Examiner |
|---|---|---|
| The Hague | 14 December 2023 | Remy, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 6677

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2023

| Patent document cited in search report | | Publication date | Patent family member(s) | | Publication date |
|---|---|---|---|---|---|
| JP 2018107433 | A | 05-07-2018 | JP | 2018107433 A | 05-07-2018 |
| | | | KR | 20180076311 A | 05-07-2018 |
| US 2020185256 | A1 | 11-06-2020 | CN | 111293026 A | 16-06-2020 |
| | | | CN | 210722949 U | 09-06-2020 |
| | | | JP | 3224900 U | 30-01-2020 |
| | | | JP | 2020092260 A | 11-06-2020 |
| | | | KR | 20200070118 A | 17-06-2020 |
| | | | TW | M597508 U | 21-06-2020 |
| | | | TW | 202109728 A | 01-03-2021 |
| | | | US | 2020185256 A1 | 11-06-2020 |
| CN 107644802 | B | 06-09-2019 | NONE | | |

EPO FORM P0459

For more details about this annex : see Official Journal of the European Patent Office, No. 12/82